# EUROPEAN PATENT SPECIFICATION

(11) **EP 1 089 433 B1**
(45) Date of publication and mention of the grant of the patent: **14.11.2007**
(21) Application number: 99870200.5
(22) Date of filing: 30.09.1999
(51) Int. Cl.: H03K 19/094, H03K 19/00, H03K 19/017, G09G 3/36, H03K 19/0185

(54) **A method and apparatus for level shifting**
Verfahren und Vorrichtung zur Pegelverschiebung
Procédé et dispositif de décalage de niveau

(43) Date of publication of application: 04.04.2001
(73) Proprietor: INTERUNIVERSITAIR MICRO-ELEKTRONICA CENTRUM VZW, 3001 Heverlee (BE); Universiteit Gent, 9000 Gent (BE)
(72) Inventor: Doutreloigne, Jan, 9000 Gent (BE)
(74) Representative: Van Malderen, Joëlle

(56) References cited:
- US-A- 4 835 417
- PATENT ABSTRACTS OF JAPAN vol. 016, no. 333 (P-1389), 20 July 1992 (1992-07-20) & JP 04 098687 A (HITACHI LTD), 31 March 1992 (1992-03-31)
- PATENT ABSTRACTS OF JAPAN vol. 1995, no. 03, 28 April 1995 (1995-04-28) & JP 06 343034 A (NIPPON MOTOROLA LTD), 13 December 1994 (1994-12-13)

## Description

### Field of the invention

The invention relates to methods and circuits for low consuming high-voltage level shifting and related circuitry.

### Background of the invention

In many integrated circuits, such as display drivers, a combination of high-voltage driving capability (an output voltage swing up to 100V or more) and a digital control by means of standard 5V CMOS logic is required. Hence, complex level-shifting circuits are needed to convert the 5V control signals into the desired high-voltage output waveforms. Moreover, in many of those applications, the system is battery-powered and very strong constraints are put on the power consumption of the level-shifters. A potential interesting application where both high-voltage driving capability and extremely low power consumption are required, is the design of driver chips for cholesteric texture LCDs [J. W. Doane, D. K. Yang and Z. Yaniv, "Front-lit flat panel display from polymer stabilized cholesteric textures", proceedings of the 12th International Display Research Conference (Japan 92), p. 73.]. Quite high voltage levels (50V rms) are necessary to switch this kind of liquid crystal from one stable state to another, but its inherent memory function (images remain unchanged on the screen without the need for continuous refreshing) is undoubtedly a major advantage compared to other types of liquid crystals, as it allows us to implement certain display systems with very low image frame rates and a high degree of power efficiency. Consequently, these cholesteric texture LCDs are ideal components in battery-operated display systems with slowly or sporadically varying images, but for the generation of the required waveforms on the display rows and columns, high-voltage driver circuits with very low power dissipation have to be developed.

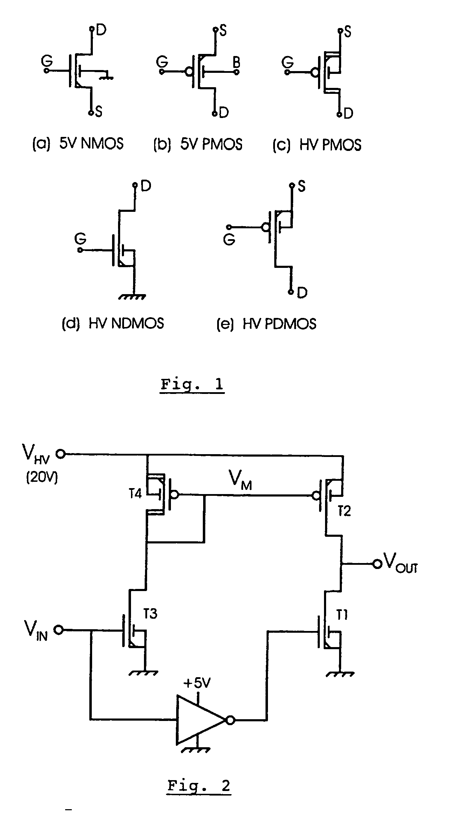

In most high-voltage CMOS technologies 5 different kinds of n- and p-type MOS transistors, as shown in Fig. 1, are used. The devices (a) and (b) are standard non-floating NMOS and floating PMOS transistors for normal 5V operation (used in the CMOS control logic), while the PMOS device (c) can float up to a high voltage with respect to the substrate potential. However, said PMOS device (c)'s and V_{DS} are limited to 5V, and hence this transistor is ideally suited for controlling the gate electrode of the PDMOS transistor in the output stage and also serves perfectly as an active load in the voltage mirrors. The MOSFETs which have to withstand a high voltage between their source and drain electrodes (such as the ones in the output stage or the switching transistors in the voltage mirrors) are the non-floating NDMOS and floating PDMOS devices (d) and (e).

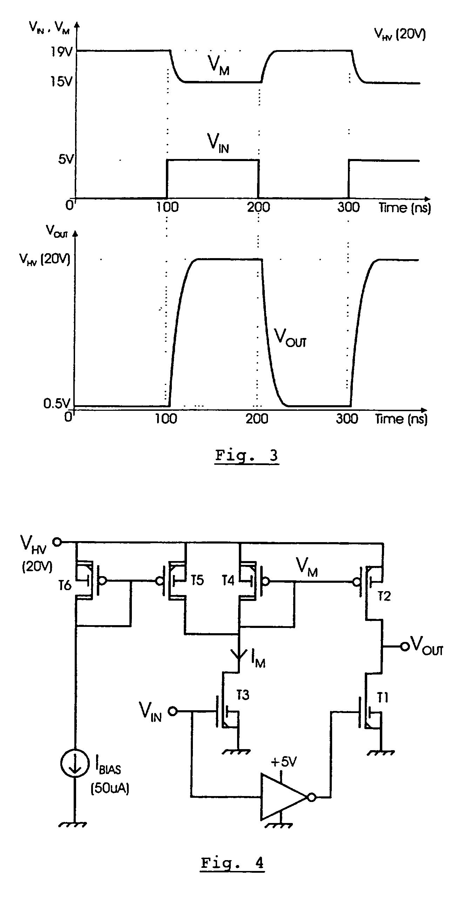

The basic version of a high-voltage level-shifter is the well known circuit of Fig. 2. It exhibits a classic complementary output stage with independent control of the gate voltages of the NDMOS and PDMOS devices T1 and T2. Standard 5V logic is used to control the NDMOS, while a voltage mirror (T3,T4) is required to apply the appropriate gate signal to the PDMOS. Unfortunately, the gate control of the PDMOS device T2 is not optimum, as demonstrated by the HSPICE-simulations of Fig. 3, which are based on transistor model parameters from a high-voltage extension of a 0.7µm CMOS technology. When the input data line is switched from a logical "1" to "0", the V_{GS} of T4 and T2 is not entirely discharged to 0V but to a value of approximately -1V, being the threshold voltage of the PMOS transistor T4. Consequently, the PDMOS output transistor T2, having a slightly different threshold voltage, is not driven 100% into cut-off operation, resulting in an output voltage of 0.5V instead of the ideal 0V value. Moreover, the simultaneous conduction of both DMOS transistors in the output stage represents a significant waste of energy.

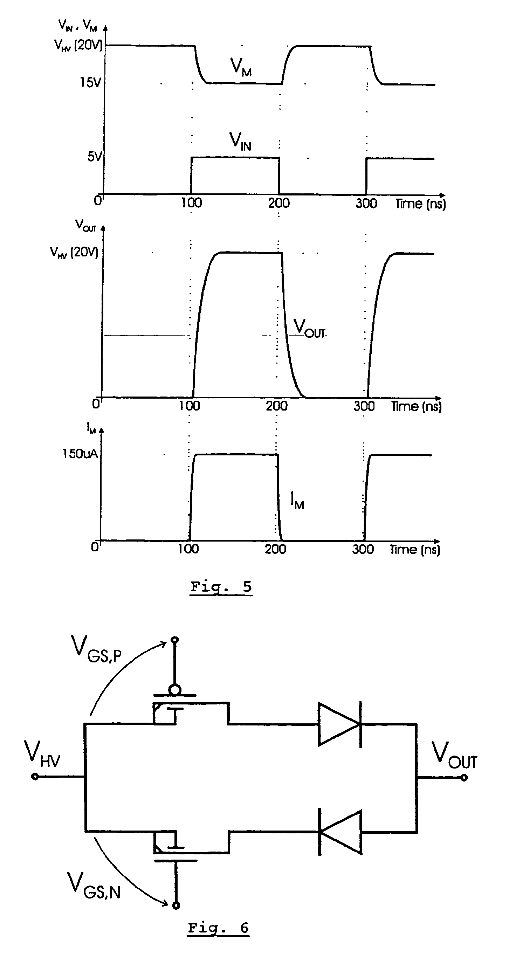

This problem can be solved by discharging the V_{GS} of the PDMOS output transistor completely to 0V by means of a current mirror as illustrated in Fig. 4. On the "1" to "0" transition of the input signal, the constant current source I_{BIAS} and the current mirror (T5,T6) ensure that the V_{GS} of T2 and T4 is pulled down to 0V, resulting in a satisfactory logical "0" state at the driver output and avoiding the unnecessary power dissipation in the output DMOS transistors. Fig. 5 shows the HSPICE-simulation results on this circuit. An alternative for the circuit of Fig. 4 is the level-shifter proposed by M. Declercq and M. Schubert [M. Declercq and M. Schubert, "Circuit intermédiaire entre un circuit logique à basse tension et un étage de sortie à haute tension réalisés dans une technologie CMOS standard", patent 92 06030 at the *Institut National de la Propriété Industrielle,* Paris (France).], where the current source I_{BIAS} is no longer constant but controlled by the inverted input signal, resulting in a nicely balanced circuit configuration. However, the level-shifter of Fig. 4 and all the variations described in the literature, have one major drawback: they show continuous power dissipation in the voltage mirrors for a logical "0" and/or a logical "1" at the data input. In the case of the simulations in Fig. 5 for instance, it can be seen that a stationary 150 µA current is flowing through the drain terminal of transistor T3 when a logical "1" bit is applied to the data input. For obvious reasons, such is unacceptable in battery-powered applications.

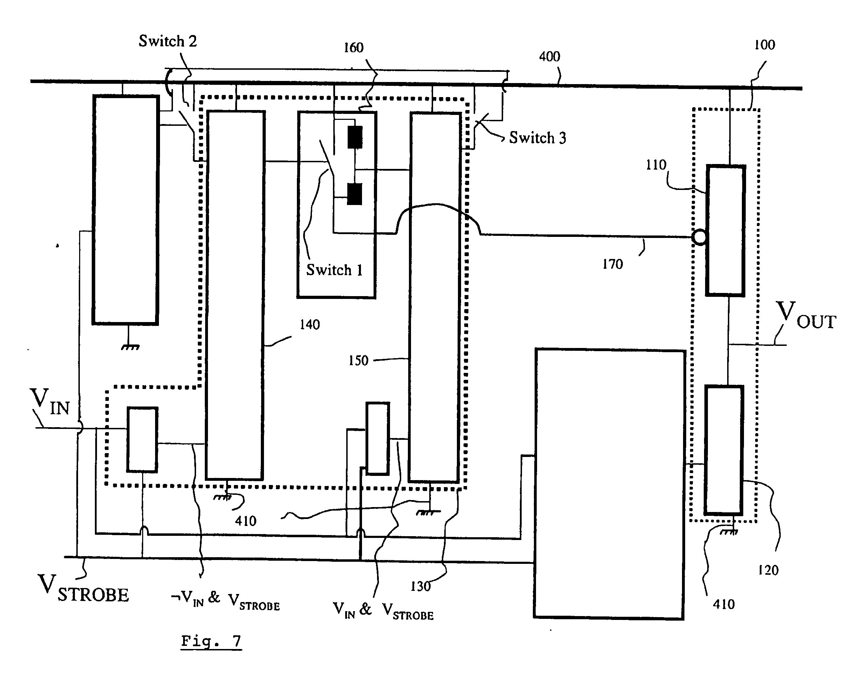

When considering cholesteric texture LCD drivers low-power high-voltage CMOS level-shifters cannot be used directly because they have a purely digital output (the output voltage is switched between 0V and the V_{HV} supply voltage), while the cholesteric texture LCDs need waveforms which are far more complicated. Some of the driving schemes require 3-, 4- or even 5-level logic, and others need analog multiplexers to select complex analog waveforms. Hence, for all those applications, some kind of analog switch, capable of withstanding high voltages and exhibiting the same extremely low power dissipation as high-voltage level-shifters, is needed. The classic circuit for a high-voltage analog switch is shown in Figure 6. In this complementary analog switch, 2 diodes have been included to avoid the unwanted conduction of the drain-bulk diodes in the DMOS transistors. To obtain the conducting "ON"-state of the switch, the source-gate voltages of the DMOS devices should be V_{GS,N} = 5V and V_{GS,P} = -5V . To turn off the switch (isolating "OFF"-state), V_{GS,N} = V_{GS,P} = 0V is needed. Although this circuit is widely used in all kinds of applications, it has some important drawbacks: Since the gate potential of the PDMOS device has to be 5V lower than the V_{HV} analog signal to put the switch in the conducting "ON"-state and since the gate potential of the NDMOS device should exceed the V_{HV} signal with 5V under the same circumstances, the voltage range of the control circuit (responsible for applying the appropriate signals to the gates of the 2 DMOS transistors) should be at least 10V in excess of the total V_{HV}-range. For the control of the NDMOS device, a double voltage mirror is required. The first one shifts the 5V control input signals upwards towards an auxiliary supply voltage that is at least 5V higher than the highest V_{HV}-value, and then the second voltage mirror shifts these signals downwards to the V_{HV}-level. The choice of the transistor parameters in this double voltage mirror is extremely critical and very special care has to be taken to avoid excessive voltages on the gates of the transistors. Small deviations of the real transistor parameters from the values used in the simulations could result in transistor breakdown. This classic high-voltage analog switch uses a floating NDMOS device, meaning that its bulk can float up to a high voltage with respect to the substrate potential. Unfortunately, in many high-voltage CMOS technologies only non-floating NDMOS transistors (where the substrate acts as the transistor bulk) are available.

In summary it can be stated that in the state of the art no high-voltage level shifting circuit with low power consumption is found. Indeed in state of the art level shifting circuitry simultaneous conduction of the output stage transistors or of the circuitry controlling these output stage transistors is observed, leading to continuous power dissipation. Also conventional analog switch concepts are not suited for high-voltage switching. Such analog switch will need control circuitry, such as in the level-shifters, suited for high-voltage switching and with low power consumption, which are not available in the state of the art.

Patent application JP04098687-A relates to an output buffer circuit for reducing the response delay. The circuit comprises a switch element between each of two level conversion circuits and an output circuit part. The switch element is controlled by a tristate control signal arranged for switching the output of the output circuit. When activated by a control signal a bipolar output transistor in the output circuit can be electrically isolated, which brings the buffer output in a high-impendance state. The level conversion circuits have continuous power dissipation.

### Aim of the invention

It is an aim of the invention to provide circuitry which can be used in high-voltage level shifting circuits and analog switches which have no continuous power dissipation and no simultaneous conduction of the output stage transistors. The use of said circuitry results in extremely low power consumption in said high-voltage level shifters and analog switches. Said circuitry enable implementation of dynamic control of the charge on the gate electrodes of the high-voltage output transistor.

### Summary of the invention

In the invention an apparatus or circuit, which has an output voltage, is presented. Said apparatus comprises an output circuit and at least one input circuit. In said output circuit a first and second part can be distinguished. Said first and second part are either electrically complementary or electrically equivalent. Each of said parts of said output circuit has an input terminal. Said apparatus implements a dynamic control principle for at least one of said parts of said output circuit. With dynamic control principle is meant that said input circuit sets at least one of said input terminals to a voltage level being related to an externally inputted input voltage of said input circuit only when an inputted strobe voltage is being set externally to a first predetermined voltage level and stores the latest voltage level on said input terminal when said inputted strobe voltage is being set to a second predetermined voltage level. Such storage is enabled by electrically isolating said input terminal from the rest of the circuitry.

In an embodiment of the invention said apparatus is a high-voltage level shifting circuit with electrically complementary first and second parts in said output circuit. It is sufficient to have one input circuit.

In another embodiment of -the- invention said apparatus is an analog switch circuit with electrical equivalent first and second parts in said output circuit. In such circuit both said first and second part are being controlled by an input circuit.

In yet another embodiment said apparatus is a combination of said digital high-voltage level shifting circuit and said analog switch circuit. Such combination is able of generating multiple-level logic.

In yet another embodiment said apparatus is an analog multiplexer with high-voltage driving capability and zero static power consumption. This analog multiplexer allows us to make an electrical connection (with very low resistance) between its output and a first analog input signal, or between its output and a second analog input signal, depending on the logical value of a 5V input control signal.

### Brief description of the drawings

Figure 1 shows an overview of potential CMOS devices being used in the invented circuitry.

Figure 2 shows a prior art high-voltage level-shifter.

Figure 3 shows HSPICE simulations of said prior art high-voltage level-shifter operation.

Figure 4 shows another prior art high-voltage level-shifter.

Figure 5 shows HSPICE simulations of Figure 4 circuit.

Figure 6 represents a classical analog switch circuit.

Figure 7 shows a first configuration, for level-shifting, according to an embodiment of the invention.

Figure 8 shows a second configuration, for analog switching, according to an embodiment of the invention.

Figure 9 shows a realization according to the first configuration described in the invention.

Figure 10 shows HSPICE simulations for the circuit of Figure 9.

Figure 11 shows HSPICE simulations for the circuit of Figure 9.

Figure 12 shows an extension of the circuit of Figure 9, preventing further discharging of gate capacitances.

Figure 13 shows HSPICE simulations for the circuit of Figure 12.

Figure 14 shows HSPICE simulations for the circuit of Figure 12.

Figure 15 shows a novel analog switch concept with two PMOS devices (300) (310).

Figure 16 shows said novel analog switch of Figure 15, with both inputs of said PMOS devices (300) (310), being controlled by dynamic level-shifters (320) (330), according to the second configuration, described in the invention.

Figure 17 shows a particular realization of the circuit of Figure 16.

Figure 18 shows an analog multiplexer configuration, exploited circuitry described in the invention.

Figure 19 shows a symbolic representation of such an analog multiplexer.

Figure 20 shows HSPICE simulations of the circuit of Figure 18.

Figure 21 shows a driver architecture for which the invented circuitry can be used.

Figure 22 shows a display pattern, being used for simulations.

Figure 23 shows the HSPICE simulations for the invented circuitry, being used for the driver architecture of Figure 21 and for the display pattern of Figure 22.

### Detailed description of the invention

A level shifting circuit has as functionality that it produces an output voltage from an input voltage. Said output voltage has a first range. Said input voltage has a second range. In a high-voltage level shifting circuit said first range is larger than said second range. Said input voltage can be between a first voltage level (e.g., a digital '1' or 5V) and a second voltage level (e.g. a digital '0' or 0V), the difference between said voltage levels defining said input voltage range. Said output voltage can be between a third (e.g., 50V) and a fourth voltage level (e.g., 0V), the difference between the latter voltage levels defining said output voltage range. Said input voltage can be denoted to be two-level as in ideal circumstances it is considered to be either the first or the second voltage level. Naturally in real circumstances deviations from said levels occur. Whenever said deviations are within the margin accepted for the technology used, the input voltage can still be denoted to be two-level. Similar considerations occur for said output voltage where said third and fourth voltage levels define the two levels of said output voltage.

In a general scheme of a level shifting circuit an output stage or output circuit (100) and an input stage or input circuit (130) can be distinguished. Said output circuit generates said output voltage. Said input circuit controls said output circuit and can input said input voltage. Said input circuit sets at least one of said input terminals (170) to a voltage level being related to an externally inputted input voltage of said input circuit. Said relation is predetermined. Said output circuit typically comprises two parts (110) (120). Each of said parts has an input terminal, connected to said input circuit, enabling the latter circuit to control the operation of said parts. Besides its input terminal each of said parts has two connections. For each of said parts its connections can be labeled as being connected to a high-voltage level or a low-voltage level. These voltage levels should be considered to be relative to each other. Said parts are electrically complementary, meaning that when the current through said first part is determined by the voltage between its input terminal and its connection to a high-voltage level, then the current through the second part is determined by the voltage between its input terminal and its connection to a low-voltage level.

In a first configuration (Figure 7), being suited for level-shifting, said first (110) and second part (120) are placed in series. An output circuit (100), comprising a first (110) and a second part (120), and at least one input circuit (130), being connected to at least one of said parts, here said first part, are observed.

Said input circuit comprises of two subcircuits (140), (150) and a switch circuit (160). The first part is connected at one of its connections to the third voltage level (400). The second part is connected at one of its connections to the fourth voltage level (410). The remaining connections of said parts are connected together and define said output voltage of the level shifting circuit. The operation of such configuration is based on the fact that the input circuit controls said output circuit such that either said first part or said second part is active. With active is meant that said parts are conducting or current is flowing through it from its connections, such that said output voltage is either equal to said third voltage level or equal to said fourth voltage level within acceptable margins. Said first part can be but is not limited to be a PDMOS device. Said second part can be but is not limited to be a NDMOS device. The connections are then defined to be either source or drain dependent of whether they are connected to a high-voltage or low-voltage level and depending on the type of the device. The input terminals can then be defined to be gates. Even when said parts are more than a single device, the terms source or drain will be further exploited or generalized to said parts also. The selection of the voltages on said input terminals is such that simultaneous conducting of said first and said second part is prevented.

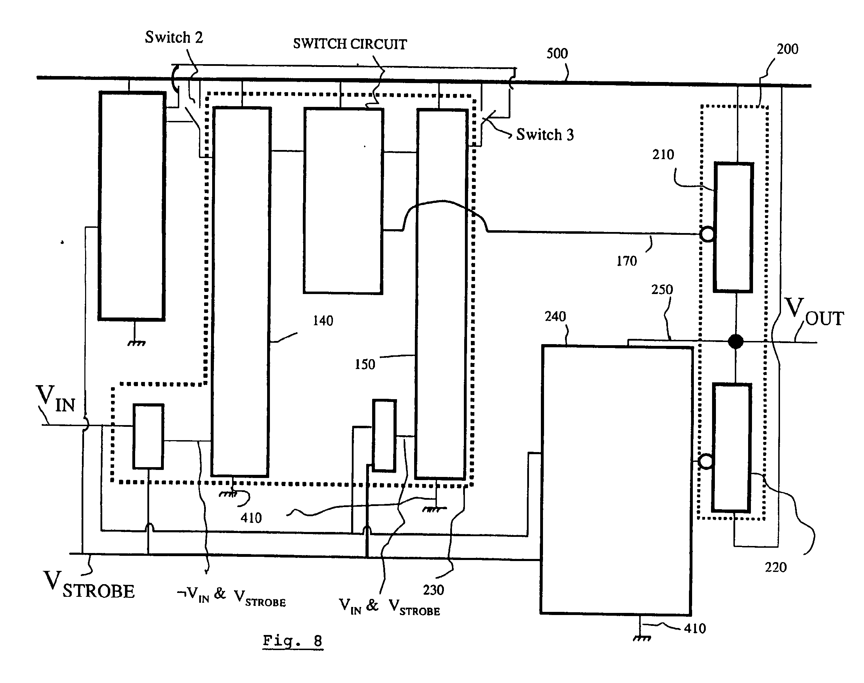

In a second configuration (Figure 8), being suited for analog switching, and being a slight variant of said first configuration, said first (210) and second part (220) are placed in series. Both said first and said second part are connected each at one of its connections to the third voltage level (500). The remaining connections of said parts are connected together and define said output voltage of the analog switching circuit. The operation of such configuration is based on the fact that the input circuit controls said output circuit such that both said first part and said second part are active or non-active simultaneously. Both said first and second part can be but is not limited to be a floating PDMOS device in series with a diode. The diodes and said PDMOS devices are however differently oriented in said first and said second part. The connection in between said diode and said PDMOS device of at least one of said parts is connected to said input circuit (240) thereby realizing a virtual supply voltage 250).

Said analog switch configuration is discussed further.

First said level-shifting configuration is discussed in detail. As low power consumption is aimed at, simultaneous conducting of said first and said second part must be prevented here. This can be realized when said input circuit appropriately controls at least one of said parts and thus said input circuit must be adapted to be able to set a voltage on at least one of said input terminals. The voltage to be set on said input terminals depends according to a predetermined relation from the externally inputted voltage.

As discussed in the background of the invention, several input circuits exist but they have as drawback that they either do not provide an appropriate control or they themselves consume continuously power which can not be accepted for for instance battery-powered applications.

In the invention therefore a dynamic control principle is used, meaning that the control of the input terminal of the part under consideration, is being made dependent of an additional signal, denoted the strobe signal or strobe voltage. Said strobe voltage is also provided to said input circuit. Said strobe voltage is also two-level, preferably exploiting the same voltage levels of said input voltage. When said strobe voltage is at a first strobe voltage level, the input circuit is being active and sets the input terminal under consideration at such a voltage level that the appropriate voltage level is obtained at the output of the level shifting circuit. It can be stated that the voltage level on the input terminal under consideration is related to said input voltage. When said strobe voltage is at a second strobe voltage level, the input circuit is being non-active and thus not consuming power. Moreover when said strobe voltage is at said second strobe voltage level, the input terminal under consideration should hold its latest value or thus stores this latest value. Therefore the input circuit must be such that when said strobe voltage is at said second strobe voltage level, the input terminal under consideration is electrically isolated. Its latest value is then stored by the capacitance of the input terminal. With reference to the analog switching configuration it is clear that the same dynamic control principle can be applied but then both to said first and said second part of said analog switch output stage.

Said first and said second part of said output circuit is only conducting sufficiently when the generalized gate-source voltage in absolute value exceeds with a certain positive margin a certain threshold value, depending on the configuration of said parts. Said first and said second part of said output circuit is only sufficiently non-conducting when the generalized gate-source voltage in absolute value is sufficiently below a certain threshold value, depending on the configuration of said parts, preferably said gate-source voltage being zero. Therefore the input circuit should provide the appropriate voltage level to the input terminal under consideration, thus resulting either in a gate-source voltage sufficiently close to zero when the part under consideration is expected to be non-active otherwise resulting in a gate-source voltage sufficiently exceeding the configuration dependent threshold voltage.

For the further explanation the dynamic control principle is applied to said first part of said output circuit, being the part connected to the third voltage level. A similar way of reasoning can however be used when the dynamic control principle being applied to said second part or to both.

As shown in Figure 7, a potential approach can be that for a zero gate source voltage the input terminal is electrically connected with said third voltage level via a first switch and that for a non-zero gate source voltage the voltage drop over an electronic device with respect to said third voltage is realized, said voltage drop being sufficient such that the non-zero gate source voltage exceeds in absolute value the threshold value of said first part. The voltage on said input terminal of said first part is denoted by a fifth voltage level. Said first switch can be for instance an ordinary PMOS transistor. The electronic device for realizing a voltage drop can also be an ordinary PMOS transistor with its gate connected with its drain. It is clear that said first switch must be controlled by some circuitry. Also said electronic device for realizing said voltage drop must be controlled by another circuitry, being pulling sufficient current through said electronic device.

Said first switch and said electronic device can be considered to be part of a switch circuit, with two inputs, the first being the control of said first switch and the second being the drain of the electronic device. The output of said switch circuit is then the input terminal of the part of the output circuit under consideration. Circuitry for controlling said two inputs of said switch circuit is needed. Said input circuit therefore comprises a first and second subcircuit. As different operation is necessary dependent on the input voltage and via the dynamic control principle said operation is also depending on the strobe voltage, it can be stated that said first subcircuit is being active when said input voltage is being set to said second voltage level and said strobe signal being set to said first voltage level and said first subcircuit is being non-active for other combinations. The second subcircuit is being active when both said input voltage and said strobe voltage being set at said first voltage level and is non-active otherwise. As the first subcircuit is connected to said first switch, with active is meant closing said first switch and thus providing an appropriate voltage for the transistor configuration in said first switch. As the second subcircuit is connected to the drain of said electronic device, with active is meant pulling current through said electronic device. Said subcircuits can have a similar configuration, for instance a series connection of a PMOS and NDMOS transistor. The only difference is then the input supplied to said subcircuits being for the first circuit a logical AND operation between a logically inverted input voltage and said strobe voltage and for the second circuit a logical AND operation between said input voltage and said strobe voltage. Also a different configuration of said subcircuits is allowable. An essential feature of the configuration of said switch circuit and the interconnection with said subcircuits must be that when said strobe voltage is set to a second voltage level that then the input terminal under consideration is electrically isolated.

Additional circuitry can be provided preventing slow discharging of the capacitance of the input terminal, used to hold its latest value, via said first switch. This can be realized by connecting the control terminal of said first switch to said third voltage level by using a second switch. Also the voltage drop over said electronic device is preferably set to zero by using a third switch. Said second and third switches can be PMOS transistors, being controlled by a circuit, closing said second and third switches when the input terminal has to be electrically isolated from the input circuit.

As described above, said input circuits can also be exploited in other configurations for instance for realizing an analog switch. Indeed when both said first and second part of said output circuit are designed to be electrically equivalent instead of complementary, an analog switch can be realized. One could define said third voltage level as a first side of said analog switch and as other side of said analog switch said output voltage. The input voltage is then used for setting said analog switch on or off. As it is necessary to let both parts of said output circuit on or off simultaneously for obtaining excellent switching behavior, said dynamic control principle can be exploited again. Such an analog switch will then comprise two of said input circuits. Each of said input circuits is then connected to an input terminal of one of said parts of said output circuit. Naturally each input circuit is connected to a different input terminal. Said input circuits are then adapted both such that they set the input terminal to which they are connected to a voltage level, being related to said input voltage of said input circuits. When said strobe voltage is equal to a first voltage level, said input terminals are set to a voltage being related to said input voltage of said input circuits. When said strobe voltage is equal to a second voltage level, said input terminals are electrically isolated from the rest of the circuit and therefore store that latest voltage on the capacitances of said input terminals. When said input voltage of said input circuits is being set to a first voltage level, then said input terminal voltages are set to a voltage level which sets both parts of said output circuit to active, thus conducting. The apparatus, also denoted analog switch, is therefore in conducting mode. When said input voltage of said input circuits is being set to a second voltage level, then said input terminal voltages are set to a voltage level which sets both parts of said output circuit to non-active, thus in non-conducting mode. The apparatus, is therefore in non-conducting mode. Functionally said output voltage of said apparatus or analog switch is substantially equal to a third voltage level when said switch is in conducting mode, and electrically isolated from said third voltage when said switch is in non-conducting mode. To realize that each part of said output circuit must at least be connected at one side to said third voltage level. In a particular realization, said first and second part of said output circuit comprise both of a floating PDMOS in series with a diode. Said diode and PDMOS devices can however by differently oriented in both parts. Each of said input circuits are connected to two voltage levels. A first input circuit can for instance be connected in between said third voltage and a fourth voltage level. The second input circuit is then connected in between said fourth voltage level and the side of the output circuit controlled by said input circuits not being connected to said third voltage level, thereby defining a sort of virtual supply voltage for said second input circuit.

In the further description some particular embodiments of the invention are shown.

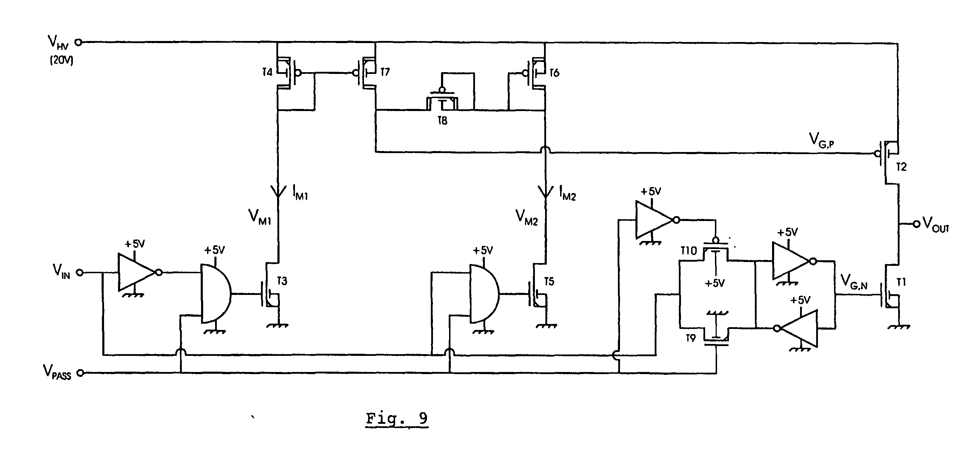

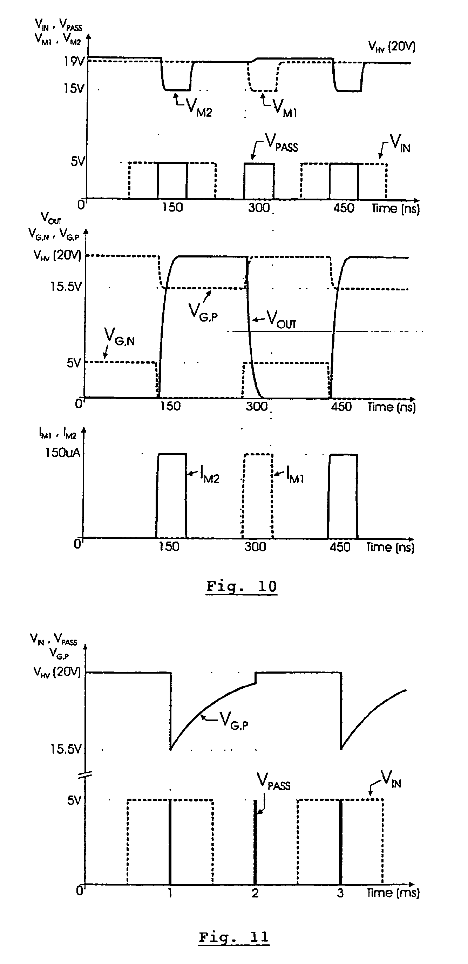

In a first embodiment a configuration with a PDMOS output transistor as first part of the output circuit is considered. In order to reduce the power consumption to an absolute minimum dynamic control of the charge on the gate capacitance of the PDMOS output transistor is used. The basic version of this design and the corresponding HSPICE-simulations are shown in Fig. 9, 10 and 11. It is seen that the operation of the whole level-shifter is controlled by a strobe voltage or signal V_{PASS}. When this strobe signal goes high (first voltage level), one of the 2 transistors T3 or T5 (according to the logical value of the input signal) will carry a 150µA drain current, causing a voltage drop of 5V over the p-type load transistor T4 or T6. For a "0" bit (second voltage level) at the data input, the 5V drop across T4 turns on transistor T7, and consequently the source-gate capacitance of the PDMOS T2 is totally discharged. Said transistor T7 acts as a switch connecting said input terminal of said PDMOS to said third voltage level. On the other hand, for a "1" bit (first voltage level) at the data input, the 5V drop across T6 will pull down the gate potential of T2 through transistor T8 (used as a simple pn-diode between its drain and bulk terminals), yielding a source-gate voltage of approximately -4.5V for the T2 output transistor. When the strobe signal goes low, the transistors T3 and T5 are switched off, and the voltage drop across T4 and T6 is reduced to about 1V. As a consequence, transistor T7 will be turned off (if the input bit was a logical "0" during the strobe pulse) or the "diode" T8 will be polarized inversely (if the input bit was "1"). In both cases, the gate electrode of the PDMOS output transistor T2 remains electrically isolated from the rest of the circuit (meaning that only high-impedance connections exist between the gate electrode and other components), and hence the charge that was previously stored on its gate capacitance during the strobe pulse (0V or -4.5V according to the input signal) will remain unchanged until the next strobe pulse is applied. This approach of using the gate capacitance of the PDMOS output transistor as a storage capacitor and updating its charge at the rhythm of a strobe signal that is synchronized to the data flow, yields an enormous reduction in power dissipation if the duration of one strobe pulse can be kept very small compared to the duration of one bit of input data (since power is consumed only during the strobe pulses). This is definitely the case for the cholesteric texture LCD drivers with their very low image frame rates. For the gate control of the NDMOS output transistor T1 in Fig. 9, a static 5V sense-amplifier is used here as it doesn't consume DC power, but also the dynamic charge control method could be applied here. The simulation results of Fig. 11 indicate that this circuit still suffers from a minor inconvenience: in between strobe pulses, the V_{GS} of T7 is set to approximately -1V, a voltage that keeps the transistor T7 at the edge of cut-off operation. As a consequence, a small but not insignificant leakage current (actually a sub-threshold current) will flow through its source and drain terminals. This current will slowly discharge the gate capacitance of the PDMOS output transistor (if a "1" bit was sampled during the strobe pulse), and if the charge is not updated on time, the level-shifter won't operate properly any more.

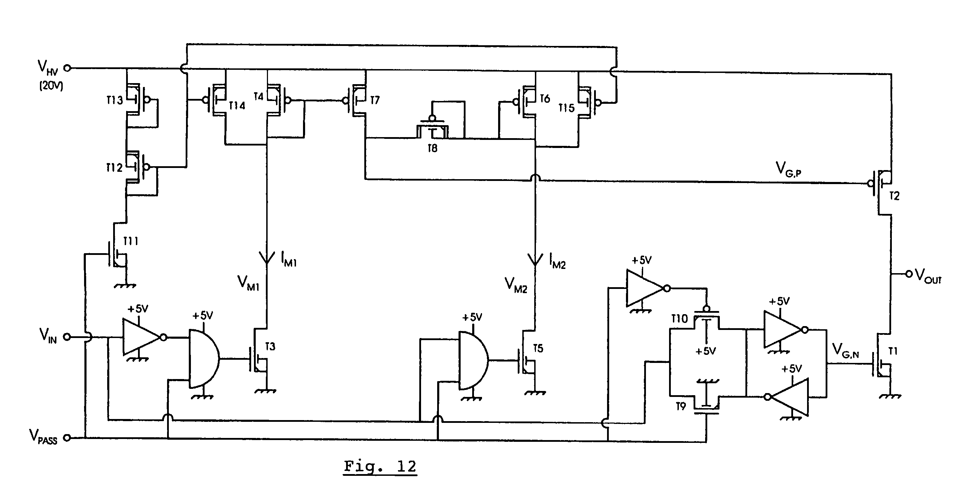

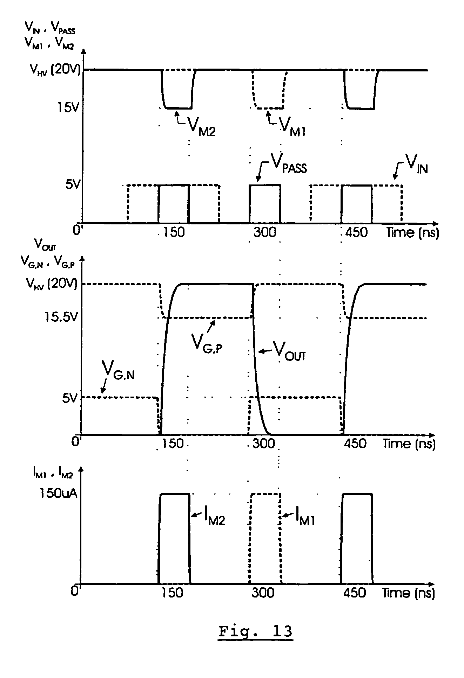

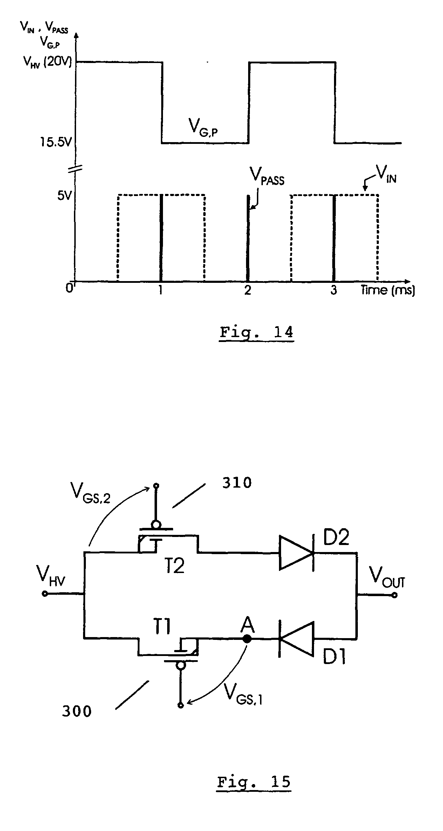

In a second embodiment of the invention this problem is taken care of in the improved circuit of Fig. 12 with the corresponding HSPICE-simulation results of Fig. 13 and 14. On the high to low transition of the strobe signal, the V_{GS} of each of the transistors T12 and T13 (which were in the conducting state during the strobe pulse) is discharged to about -1V. Since T12 and T13 are put in series, the devices T14 and T15 receive a V_{GS} of approximately -2V, and hence the voltage drop across the active loads T4 and T6 is completely discharged to 0V. Consequently, transistor T7 is driven far into its cut-off operating region with a negligible leakage current. In this way, the charge stored on the gate capacitance of the PDMOS output transistor T2 won't be affected any more between consecutive strobe pulses, as illustrated by the simulation results of Fig. 14. It is found that reliable charge storage is obtained, even at extremely low strobe signal frequencies of only a few pulses per second.

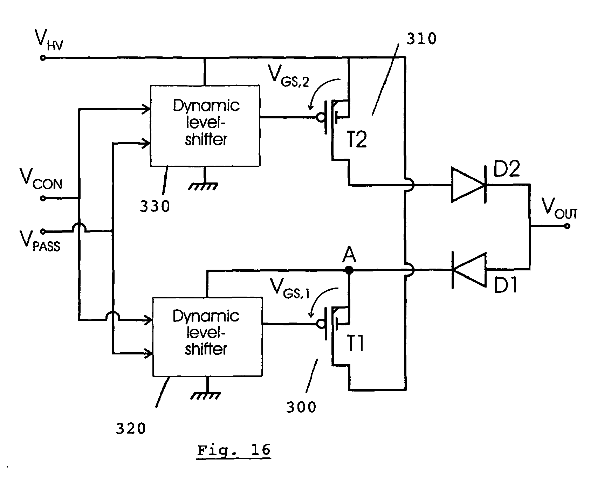

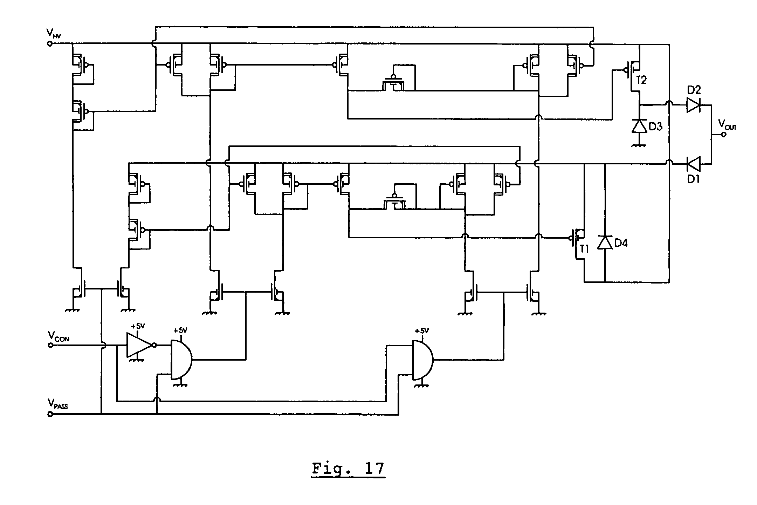

In a third embodiment of the invention the dynamic control principle is being exploited in the design of an analog switch, being suitable for use in Liquid Crystal Display drivers. A solution to the problems of the classic analog switch shown in Figure 6 and discussed before is to replace the floating NDMOS transistor by a second floating PDMOS device, as shown in Figure 15. To turn on the switch, V_{GS,1} = V_{GS,2} = -5V should be applied to the gates of the 2 PDMOS transistors, while the values V_{GS,1} = V_{GS,2} = 0V turn the switch off. In this configuration, the gate potentials of the PDMOS devices never exceed the V_{HV} analog signal, and hence the voltage range of the circuit for the dynamic control of the 2 PDMOS transistors should be only 5V higher than the total V_{HV}-range. Since only PDMOS devices are used in this schematic, the double voltage mirrors are no longer necessary and consequently a higher reliability is achieved. For the control of the PDMOS T2, the 5V switch control input signal is shifted towards the V_{HV}-level at the rhythm of a strobe pulse sequence, while for controlling the gate of PDMOS transistor T1 the 5V input signal has to be shifted towards the potential of point A, which could be considered as a kind of "virtual supply voltage" for the T1 control circuit. This is clearly shown in Figure 16. For each dynamic level-shifter, the transistor configuration of figure 12 is used, where the 5V CMOS control logic can of course be shared by the 2 level-shifters as both transistors T1 and T2 are always simultaneously in the "ON"- or "OFF"-state. So the complete architecture of the dynamically controlled high-voltage analog switch with zero static power dissipation, shown in Figure 17 is obtained. The diodes D3 and D4 were added to the circuit to achieve an almost ideal switching behavior. Diode D3 eliminates the negative voltage spikes which can be generated on the drain electrode of PDMOS T2 by capacitive effects in transistor T2 and diode D2 under certain circumstances (for some very specific waveforms). Diode D4 reduces the effect of the non-negligible drain resistance of the PDMOS T1 during the strobe-pulses.

In a fourth embodiment of the invention the novel analog switch can serve as a basic building block for even more complex high-voltage switches with zero static power consumption. For instance, a combination of this high-voltage analog switch on one hand and a purely digital high-voltage level-shifter on the other yields a high-voltage level-shifter with 3-level logic at its output. By adding a second high-voltage analog switch, a 4-level logic is obtained, etc. HSPICE-simulations on all these circuits can show proper level-shifter operation.

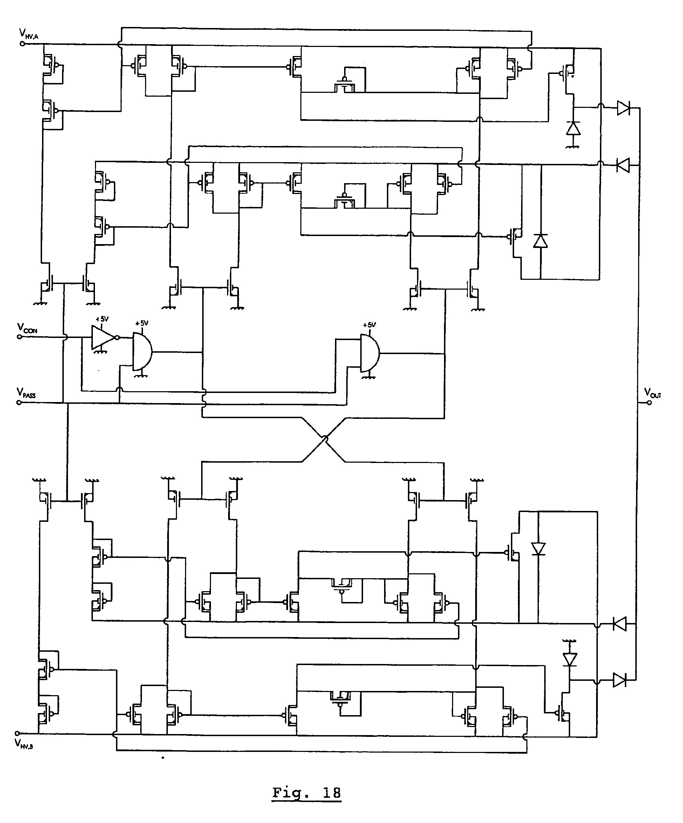

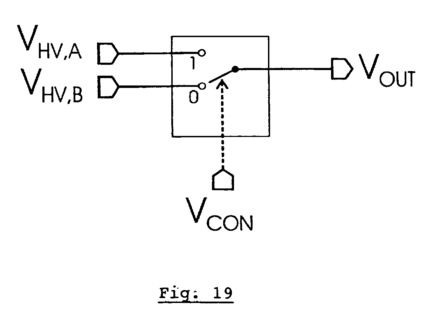

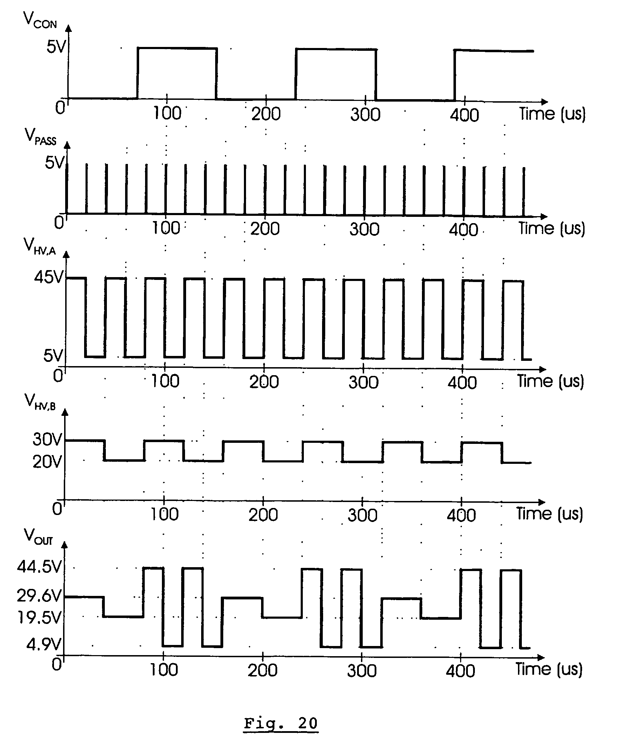

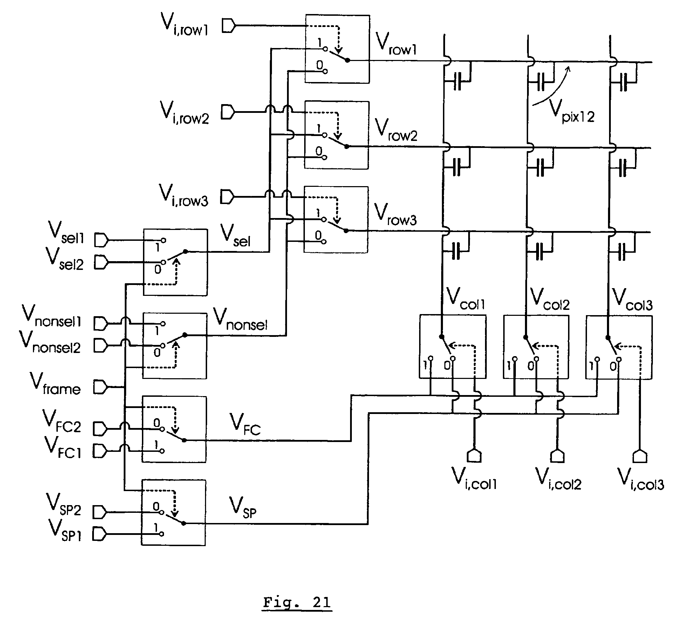

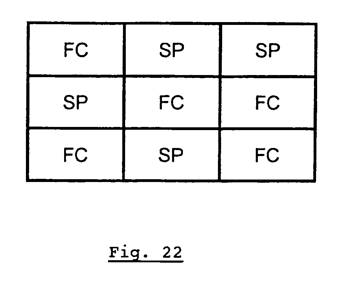

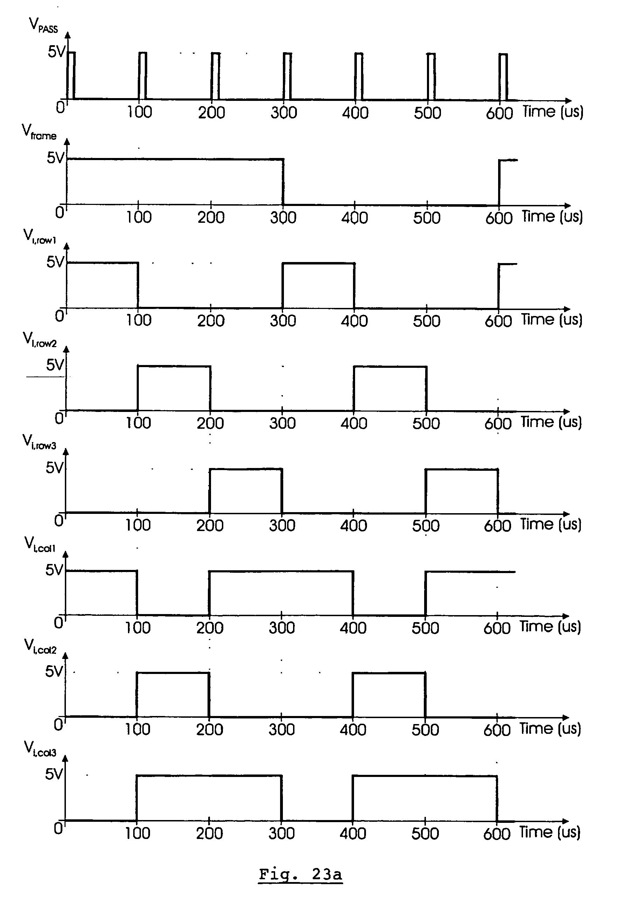

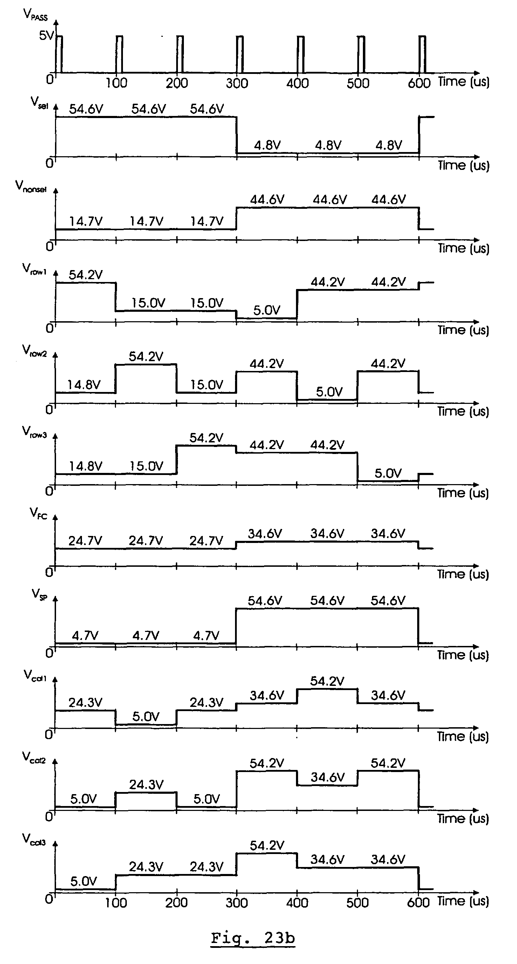

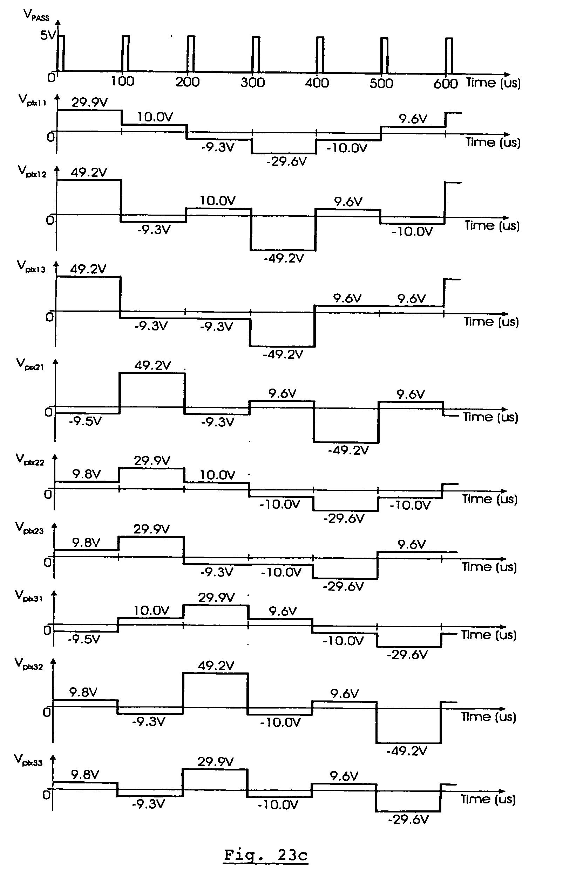

In a fifth embodiment a 2-input analog multiplexer with high-voltage driving capability and zero static power consumption is presented. This analog multiplexer allows us to make an electrical connection (with very low resistance) between its output and a first analog input signal, or between its output and the second analog input signal, depending on the logical value of a 5V input control signal. Obviously, such a multiplexer needs 2 analog switches (the first one between the output and the first analog input voltage, the second one between the output and the second analog input voltage), with complementary 5V control signals, since the second switch has to be in the "OFF"-state when the first one is conducting, or vice versa. Therefore, the same 5V CMOS control logic for both switches is used, but the connections to the voltage mirrors have to be interchanged. This can be seen in Figure 18 showing the dynamically controlled high-voltage 2-input analog multiplexer. The practical use of this novel multiplexer circuit is quite simple and straightforward. V_{HV,A} and V_{HV,B} are the high-voltage input signals and V_{OUT} the high-voltage output signal, while V_{CON} is the 5V control input signal (which selects one of the 2 analog switches in the multiplexer) and V_{PASS} the 5V strobe pulse sequence to sample the V_{CON} input data. If V_{CON} = "1" (5V) during a strobe pulse, an electrical low-resistance connection will be established between the output V_{OUT} and the input signal V_{HV,A}. On the other hand, if V_{CON} = "0" (0V) during a strobe pulse, then the output V_{OUT} will be connected to the input signal V_{HV,B}. In between strobe pulses, the multiplexer state defined during the last strobe pulse, will be maintained until the next pulse. The operation of this dynamically controlled analog multiplexer (with the exception of the strobe pulse sequence) can be represented in a simplified way by the symbol of Figure 19. In order to find out whether this dynamically controlled analog multiplexer functions satisfactorily, HSPICE-simulations are used of which the results are shown in Figure 20. These simulations (carried out on the multiplexer with a capacitive load) indicate that the multiplexer circuit operates very well. At this point, 2 important remarks should be made. Observe in the simulation results that the output voltage V_{OUT} is slightly different (maximum 0.5V deviation) from the selected analog input waveform, due to the threshold voltage of the diodes at the output of the circuit. In these simulations more strobe pulses are used than strictly necessary for the chosen input data sequence V_{CON}. The reason for this is the following: simulations have shown that abrupt changes in the high-voltage waveforms can cause variations in the source-gate voltages of the output PDMOS devices, due to the capacitive coupling between their gate and drain electrodes. So, if the V_{GS} of those transistors is not updated at the moment a sudden change in one of the high-voltage signals occurs, the V_{GS}-values could be seriously affected and the multiplexer circuit wouldn't work properly anymore. Therefore, a very simple rule of operation should always be respected: each time an abrupt change occurs in one or more of the high-voltage signals V_{HV,A}, V_{HV,B} and V_{OUT}, an extra strobe pulse V_{PASS} is required to update the V_{GS} of the PDMOS output transistors. To demonstrate that these dynamically controlled analog multiplexers are really useful components for the monolithic integration of cholesteric texture LCD drivers, extensive simulations are carried out on such a driver for a display with 3 rows and 3 columns according to a conventional "minimum swing unipolar" driving scheme. This driving scheme was found to be the best one if long-term DC compensation (spread over 2 consecutive frames) of the cholesteric texture liquid crystal is allowed. Figure 21 shows the complete driver architecture. As can be seen, the row driver consists of 5 dynamically controlled multiplexers with 2 inputs each. A first multiplexer chooses the correct row-select voltage according to the V_{frame} control signal ("1" for the first frame, "0" for the second). A second multiplexer chooses the right row-non-select voltage, also according to the value of the V_{frame} control input. Each one of the other 3 multiplexers connects the row-select voltage or the row-non-select voltage to the corresponding row of the LCD. For the column driver, an identical configuration is used, where 2 of the 5 multiplexers are responsible for selecting the appropriate "focal conic" (FC) or "stable planar" (SP) voltages according to V_{frame}. The voltages used in the simulations are the following: Vₛₑₗ₁: row select voltage, frame 1 **:** 55V, Vₛₑₗ₂ : row select voltage, frame 2 : 5V, Vₙₒₙₛₑₗ₁ : row non-select voltage, frame 1 **:** 15V, Vₙₒₙₛₑₗ₂ : row non-select voltage, frame 2 : 45V, V_{FC1} : column "focal conic" voltage, frame 1 : 25V, V_{FC2} : column "focal conic" voltage, frame 2 : 35V, V_{SP1} **:** column "stable planar" voltage, frame 1 : 5V, V_{SP2} **:** column "stable planar" voltage, frame 2 : 55V. It is already known that the gate potentials of the PDMOS output transistors in the multiplexers should be 5V lower than the high-voltage input signals in order to switch the transistors to their conducting state. Therefore, all the high-voltage input signals of the multiplexers should be at any moment at least 5V above the substrate potential which is defined as the 0V reference (ground). The signals V_{i,row1}, V_{i,row2}, V_{i,row3}, V_{i,col1}, V_{i,col2} and V_{i,col3} are the 5V CMOS input control signals for the row and column drivers, with a value of "1" (5V) for choosing the row-select and column-"focal conic" voltages, or the value "0" (0V) for choosing the row-non-select and column-"stable planar" voltages. The strobe signal V_{PASS} is common to all 10 dynamically controlled analog multiplexers. HSPICE-simulations are carried out for the display pattern of Figure 22. Using HSPICE, the following waveforms are simulated: Vₛₑₗ : row select voltage, Vₙₒₙₛₑₗ : row non-select voltage, V_{row1}, V_{row2}, V_{row3} : display row voltages, V_{FC} : column "focal conic" voltage, V_{SP} : column "stable planar" voltage, V_{col1}, V_{col2}, V_{col3} : display column voltages, V_{pix,ij} (i=1,2,3 ; j=1,2,3): voltage across the pixel between row i and column j. The simulations of Figure 23 prove that the suggested driver architecture with the dynamically controlled high-voltage analog multiplexers operates very satisfactorily. It should be noted that in the simulations a row addressing time of barely 100µs was used, while a real cholesteric texture LCD requires row addressing times of at least a few ms in a conventional driving scheme. The 100µs value was chosen only to reduce the total number of steps in the HSPICE-simulation, resulting in a shorter simulation time, which is considerable because of the large amount of transistors in the circuit (620). Anyway, a row addressing time of e.g. 10ms would yield exactly the same waveforms. From the simulation results, it is seen that the obtained waveforms are in almost perfect agreement with the theoretically expected waveforms. The maximum deviation between theory and simulation is only 0.8V and is entirely caused by the threshold voltage of the diodes at the output of the multiplexers.

## Claims

1. An apparatus for determining an output voltage comprising:
an output circuit comprising a first and a second part, each having an input terminal; and
at least one input circuit, being adapted for inputting at least a two-level input voltage and at least a two-level strobe voltage, said input circuit being adapted for setting at least one of said input terminals to an input terminal voltage level related to said input voltage when said strobe voltage is set to a first voltage level, **characterised in that** said input circuit is further adapted for electrically isolating at least one of said input terminals, said at least one input terminal thereby holding said input terminal voltage level related to said input voltage, when said strobe voltage is set to a second voltage level.

2. The apparatus as recited in claim 1, wherein said first and second part being electrically complementary.

3. The apparatus as recited in claim 1, wherein said input terminal voltage levels to be set on said input terminals being selected such that
when said input voltage being set to a first voltage level, at least one of said parts of said output circuit being active
when said input voltage being set to a second voltage level, at least one of said parts of said output circuit being non-active.

4. The apparatus as recited in claim 1, wherein said output circuit is adapted for generating an output voltage.

5. The apparatus as recited in claim 4, wherein said output voltage is level shifted with respect to said input voltage.

6. The apparatus as recited in claim 1, wherein said output circuit is connected to a third voltage level and a fourth voltage level, said third and fourth voltage levels being different.

7. The apparatus as recited in claim 1, wherein said first part is a floating PDMOS and said second part is a non-floating NDMOS.

8. The apparatus as recited in claim 1, said input circuit comprising a first and a second subcircuit, said first subcircuit being active when said input voltage being set to said second voltage level and said strobe voltage being set to said first voltage level and being non-active otherwise, said second subcircuit being active when both said input voltage and said strobe voltage being set at said first voltage level and being non-active otherwise.

9. The apparatus as recited in claim 8, said subcircuits being connected between said third voltage level and said fourth voltage level.

10. The apparatus as recited in claim 8, wherein said first subcircuit and second subcircuit each provide an input to a switch circuit, said switch circuit having an output being one of said input terminals, said switch circuit connects said switch circuit's output to said third voltage level when said first subcircuit being active, and said switch circuit sets said switch circuit's output to a fifth voltage level when said second subcircuit being active.

11. The apparatus as recited in claim 10, wherein when said switch circuit's output being connected to said third voltage level, said part of said output circuit which input terminal being connected to said switch circuit's output being non-active and when said switch circuit's output being set to a fifth voltage level, resulting in said part of said output circuit which input terminal being connected to said switch circuit's output being active.

12. The apparatus as recited in claim 11, wherein said switch circuit's output being electrically isolated when said first and second subcircuit being non-active.

13. The apparatus as recited in claim 10, wherein said first subcircuit and said second subcircuit comprising a concatenation of a PMOS, with its gate connected to its drain and a NDMOS, with its gate being the input of said subcircuit.

14. The apparatus as recited in claim 13, wherein the input of said first subcircuit being a logical AND of the logically inverted input voltage and the strobe voltage.

15. The apparatus as recited in claim 14, wherein the input of said second subcircuit being a logical AND of the input voltage and the strobe voltage.

16. The apparatus as recited in claim 15, wherein said switch circuit comprise of a first switch, being controlled by the input provided by said first subcircuit, a first end of said first switch being connected to said third voltage level, said switch circuit further comprising a one-way conducting element, a first end of said element being connected to the second end of said first switch, a second end of said element being connected to the input provided by said second subcircuit, said second end of said first switch and said first end of said element being said switch circuit's output.

17. The apparatus as recited in claim 16, wherein said first switch being a PMOS, with its gate being controlled by the input provided by said first subcircuit.

18. The apparatus as recited in claim 16, wherein said one-way conducting element being a diode.

19. The apparatus as recited in claim 16, wherein said one-way conducting element being a PMOS, with its gate connected to its source and its bulk.

20. The apparatus as recited in claim 10, further comprising a second and third switch and a circuit, controlling said second and third switch, a first end of said second switch being connected to said third voltage level, a second end of said second switch being connected to the input provided by said first subcircuit to said switch circuit, a first end of said third switch being connected to said third voltage level, a second end of said third switch being connected to the input provided by said second subcircuit to said switch circuit, said circuit closing said second and third switches when the input terminal of said part of said output circuit being connected to said switch circuit's output has to be electrically isolated from said input circuit.

21. The apparatus as recited in 20, said second and third switch being PMOS devices with their gate being connected to said circuit.

22. The apparatus as recited in claim 20, wherein said circuit being a concatenation of two PMOS, with their gate connected to their drain and a NDMOS device, with its gate connected to said strobe voltage.

23. The apparatus as recited in claim 1, being realized in CMOS technology.

24. The apparatus as recited in claim 1, said first and second part being electrically equivalent.

25. The apparatus as recited in claim 24, comprising two of said input circuits, each of said input circuits being connected to one of said input terminals, both said input circuits being adapted for setting at the input terminal to which said input circuit be connected to an input terminal voltage level related to said input voltage when said strobe voltage being set to a first voltage level and being adapted for electrically isolating the input terminal to which said input circuit be connected when said strobe voltage being set to a second voltage level.

26. The apparatus as recited in claim 25, wherein said input terminal voltage levels to be set on said input terminals being selected such that
when said input voltage being set to a first voltage level, both said parts of said output circuit being active, thereby setting said apparatus in conducting mode
when said input voltage being set to a second voltage level, both said parts of said output circuit being non-active, thereby setting said apparatus in non-conduction mode.

27. The apparatus as recited in claim 26, wherein said output voltage being related to a third voltage level when said apparatus is in conducting mode and electrically isolated from said third voltage level when said apparatus is in non-conducting mode.

28. The apparatus as recited in claim 24, wherein each part of said output circuit being connected at one side to said third voltage level.

29. The apparatus as recited in claim 24, wherein said first part and said second part being a floating PDMOS in series with a diode.

30. The apparatus as recited in claim 28, wherein at least one of said two input circuits, comprising two subcircuits, said subcircuits being connected in between a fourth voltage level and the side of the output circuit controlled by said input circuit not being connected to said third voltage level.

## Patentansprüche

1. Vorrichtung zum Bestimmen einer Ausgangsspannung, umfassend:
eine Ausgangsschaltung, die einen ersten und einen zweiten Teil umfasst, die jeweils einen Eingangsanschluss aufweisen; und
mindestens eine Eingangsschaltung, die ausgelegt ist, um mindestens eine zweistufige Eingangsspannung und mindestens eine zweistufige Abtastimpulsspannung einzugeben, wobei die Eingangsschaltung ausgelegt ist, um mindestens einen der Eingangsanschlüsse auf einen Eingangsanschluss-Spannungspegel einzustellen, der mit der Eingangsspannung in Beziehung steht, wenn die Abtastimpulsspannung auf einen ersten Spannungspegel eingestellt ist, **dadurch gekennzeichnet, dass** die Eingangsschaltung ferner ausgelegt ist, um mindestens einen der Eingangsanschlüsse elektrisch zu isolieren, wobei der mindestens eine Eingangsanschluss **dadurch** den Einganganschluss-Spannungspegel, der mit der Eingangsspannung in Beziehung steht, hält, wenn die Abtastimpulsspannung auf einen zweiten Spannungspegel eingestellt ist.

2. Vorrichtung nach Anspruch 1, wobei sich der erste und der zweite Teil elektrisch ergänzen.

3. Vorrichtung nach Anspruch 1, wobei die Eingangsanschluss-Spannungspegel, die bei den Eingangsanschlüssen eingestellt werden sollen, derart ausgewählt sind, dass
wenn die Eingangsspannung auf einen ersten Spannungspegel eingestellt ist, mindestens einer der Teile der Ausgangsschaltung aktiv ist;
wenn die Eingangsspannung auf einen zweiten Spannungspegel eingestellt ist, mindestens einer der Teile der Ausgangsschaltung inaktiv ist.

4. Vorrichtung nach Anspruch 1, wobei die Ausgangsschaltung ausgelegt ist, um eine Ausgangsspannung zu erzeugen.

5. Vorrichtung nach Anspruch 4, wobei der Pegel der Ausgangsspannung mit Bezug auf den der Eingangsspannung verschoben ist.

6. Vorrichtung nach Anspruch 1, wobei die Ausgangsschaltung mit einem dritten Spannungspegel und einem vierten Spannungspegel verbunden ist, wobei der dritte und der vierte Spannungspegel verschieden sind.

7. Vorrichtung nach Anspruch 1, wobei der erste Teil ein schwebender PDMOS ist und der zweite Teil ein nicht schwebender NDMOS ist.

8. Vorrichtung nach Anspruch 1, wobei die Eingangsschaltung eine erste und eine zweite untergeordnete Schaltung umfasst, wobei die erste untergeordnete Schaltung aktiv ist, wenn die Eingangsspannung auf den zweiten Spannungspegel eingestellt ist und die Abtastimpulsspannung auf den ersten Spannungspegel eingestellt ist, und anderenfalls inaktiv ist, wobei die zweite untergeordnete Schaltung aktiv ist, wenn sowohl die Eingangsspannung als auch die Abtastimpulsspannung bei dem ersten Spannungspegel eingestellt sind, und anderenfalls inaktiv ist.

9. Vorrichtung nach Anspruch 8, wobei die untergeordneten Schaltungen zwischen dem dritten Spannungspegel und dem vierten Spannungspegel verbunden sind.

10. Vorrichtung nach Anspruch 8, wobei die erste untergeordnete Schaltung und die zweite untergeordnete Schaltung jede einen Eingang für einen Schaltkreis bereitstellen, wobei der Schaltkreis einen Ausgang aufweist, der einer der Eingangsanschlüsse ist, wobei der Schaltkreis den Ausgang des Schaltkreises mit dem dritten Spannungspegel verbindet, wenn die erste untergeordnete Schaltung aktiv ist, und wobei der Schaltkreis den Ausgang des Schaltkreises auf einen fünften Spannungspegel einstellt, wenn die zweite untergeordnete Schaltung aktiv ist.

11. Vorrichtung nach Anspruch 10, wobei, wenn der Ausgang des Schaltkreises mit dem dritten Spannungspegel verbunden ist, der Teil der Ausgangsschaltung, dessen Eingangsanschluss mit dem Ausgang des Schaltkreises verbunden ist, inaktiv ist, und wenn der Ausgang des Schaltkreises auf einen fünften Spannungspegel eingestellt ist, der Teil der Ausgangsschaltung, dessen Eingangsanschluss mit dem Ausgang des Schaltkreises verbunden ist, aktiv wird.

12. Vorrichtung nach Anspruch 11, wobei der Ausgang des Schaltkreises elektrisch isoliert ist, wenn die erste und die zweite untergeordnete Schaltung inaktiv sind.

13. Vorrichtung nach Anspruch 10, wobei die erste untergeordnete Schaltung und die zweite untergeordnete Schaltung eine Verkettung eines PMOS, dessen Gate mit seinem Drain verbunden ist, und einen NDMOS umfassen, dessen Gate der Eingang der untergeordneten Schaltung ist.

14. Vorrichtung nach Anspruch 13, wobei der Eingang der ersten untergeordneten Schaltung ein logisches AND der logisch umgekehrten Eingangsspannung und der Abtastimpulsspannung ist.

15. Vorrichtung nach Anspruch 14, wobei der Eingang der zweiten untergeordneten Schaltung ein logisches AND der Eingangsspannung und der Abtastimpulsspannung ist.

16. Vorrichtung nach Anspruch 15, wobei der Schaltkreis einen ersten Schalter umfasst, der von dem Eingang gesteuert wird, der von der ersten untergeordneten Schaltung bereitgestellt wird, wobei ein erstes Ende des ersten Schalters mit dem dritten Spannungspegel verbunden ist, wobei der Schaltkreis ferner ein Einwegleitungselement umfasst, wobei ein erstes Ende des Elements mit dem zweiten Ende des ersten Schalters verbunden ist, wobei ein zweites Ende des Elements mit dem Eingang verbunden ist, der von der zweiten untergeordneten Schaltung bereitgestellt wird, wobei das zweite Ende des ersten Schalters und das erste Ende des Elements der Ausgang des Schaltkreises sind.

17. Vorrichtung nach Anspruch 16, wobei der erste Schalter ein PMOS ist, dessen Gate von dem Eingang gesteuert wird, der von der ersten untergeordneten Schaltung bereitgestellt wird.

18. Vorrichtung nach Anspruch 16, wobei das Einwegleitungselement eine Diode ist.

19. Vorrichtung nach Anspruch 16, wobei das Einwegleitungselement ein PMOS ist, dessen Gate mit seiner Source und seiner Masse verbunden ist.

20. Vorrichtung nach Anspruch 10, ferner umfassend einen zweiten und einen dritten Schalter und eine Schaltung, die den zweiten und dritten Schalter steuert, wobei ein erstes Ende des zweiten Schalters mit dem dritten Spannungspegel verbunden ist, ein zweites Ende des zweiten Schalters mit dem Eingang verbunden ist, der dem Schaltkreis von der ersten untergeordneten Schaltung bereitgestellt wird, wobei ein erstes Ende des dritten Schalters mit dem dritten Spannungspegel verbunden ist, ein zweites Ende des dritten Schalters mit dem Eingang verbunden ist, der dem Schaltkreis von der zweiten untergeordneten Schaltung bereitgestellt wird, wobei der Schaltkreis den zweiten und den dritten Schalter schließt, wenn der Eingangsanschluss des Teils der Ausgangsschaltung, der mit dem Ausgang des Schaltkreises verbunden ist, von der Eingangsschaltung elektrisch isoliert werden muss.

21. Vorrichtung nach Anspruch 20, wobei der zweite und der dritte Schalter PMOS-Vorrichtungen sind, deren Gate mit der Schaltung verbunden ist.

22. Vorrichtung nach Anspruch 20, wobei die Schaltung eine Verkettung von zwei PMOS, deren Gate mit ihrem Drain verbunden ist, und einer NDMOS-Vorrichtung ist, deren Gate mit der Abtastimpulsspannung verbunden ist.

23. Vorrichtung nach Anspruch 1, die in der CMOS-Technologie ausgeführt ist.

24. Vorrichtung nach Anspruch 1, wobei der erste und der zweite Teil elektrisch gleichwertig sind.

25. Vorrichtung nach Anspruch 24, umfassend zwei der Eingangsschaltungen, wobei jede der Eingangsschaltungen mit einem der Eingangsanschlüsse verbunden ist, wobei die beide Eingangsschaltungen zum Einstellen an einem Eingangsanschluss, mit dem die Eingangsschaltung verbunden ist, auf einen Eingangsanschluss-Spannungspegel ausgelegt sind, der mit der Eingangsspannung in Beziehung steht, wenn die Abtastimpulsspannung auf einen ersten Spannungspegel eingestellt ist, und dazu ausgelegt sind, den Eingangsanschluss, mit dem die Eingangsschaltung verbunden ist, elektrisch zu isolieren, wenn die Abtastimpulsspannung auf einen zweiten Spannungspegel eingestellt ist.

26. Vorrichtung nach Anspruch 25, wobei die Eingangsanschluss-Spannungspegel, die bei den Eingangsanschlüssen eingestellt werden sollen, derart ausgewählt sind, dass
wenn die Eingangsspannung auf einen ersten Spannungspegel eingestellt ist, beide Teile der Ausgangsschaltung aktiv sind, wodurch die Vorrichtung in einen leitenden Modus versetzt wird;
wenn die Eingangsspannung auf einen zweiten Spannungspegel eingestellt ist, beide Teile der Ausgangsschaltung inaktiv sind, wodurch die Vorrichtung in einen nicht leitenden Modus versetzt wird.

27. Vorrichtung nach Anspruch 26, wobei die Ausgangsspannung mit einem dritten Spannungspegel in Beziehung steht, wenn sich die Vorrichtung im leitenden Modus befindet, und von dem dritten Spannungspegel elektrisch isoliert ist, wenn sich die Vorrichtung im nicht leitenden Modus befindet.

28. Vorrichtung nach Anspruch 24, wobei jeder Teil der Ausgangsschaltung an einer Seite mit dem dritten Spannungspegel verbunden ist.

29. Vorrichtung nach Anspruch 24, wobei der erste Teil und der zweite Teil ein schwebender PDMOS sind, der mit einer Diode seriell verbunden ist.

30. Vorrichtung nach Anspruch 28, wobei mindestens eine der zwei Eingangsschaltungen, die zwei untergeordnete Schaltungen umfassen, wobei die untergeordneten Schaltungen zwischen einem vierten Spannungspegel und der Seite der Ausgangsschaltung verbunden sind, die von der Eingangsschaltung gesteuert wird, nicht mit dem dritten Spannungspegel verbunden sind.

## Revendications

1. Appareil pour déterminer une tension de sortie comprenant :
un circuit de sortie comprenant une première et une seconde parties, chacune ayant une borne d'entrée ; et
au moins un circuit d'entrée, étant adapté pour recevoir en entrée au moins une tension d'entrée à deux niveaux et au moins une tension d'échantillonnage à deux niveaux, ledit circuit d'entrée étant adapté pour définir au moins une desdites bornes d'entrée à un niveau de tension de borne d'entrée lié à ladite tension d'entrée lorsque ladite tension d'échantillonnage est définie à un premier niveau de tension, **caractérisé en ce que** ledit circuit d'entrée est en outre adapté pour isoler électriquement au moins une desdites bornes d'entrée, ladite au moins une borne d'entrée maintenant par ce moyen ledit niveau de tension de la borne d'entrée lié à ladite tension d'entrée, lorsque ladite tension d'échantillonnage est définie à un second niveau de tension.

2. Appareil tel qu'énoncé dans la revendication 1, dans lequel ladite première et ladite seconde parties sont électriquement complémentaires.

3. Appareil tel qu'énoncé dans la revendication 1, dans lequel lesdits niveaux de tension de la borne d'entrée à définir au niveau desdites bornes d'entrée sont sélectionnés de telle sorte que :
lorsque ladite tension d'entrée est définie à un premier niveau de tension, au moins une desdites parties dudit circuit de sortie est active,
lorsque ladite tension d'entrée est définie à un deuxième niveau de tension, au moins une desdites parties dudit circuit de sortie est non active.

4. Appareil tel qu'énoncé dans la revendication 1, dans lequel ledit circuit de sortie est adapté pour générer une tension de sortie.

5. Appareil tel qu'énoncé dans la revendication 4, dans lequel ladite tension de sortie a son niveau décalé par rapport à ladite tension d'entrée.

6. Appareil tel qu'énoncé dans la revendication 1, dans lequel ledit circuit de sortie est connecté à un troisième niveau de tension et à un quatrième niveau de tension, ledit troisième et ledit quatrième niveaux de tension étant différents.

7. Appareil tel qu'énoncé dans la revendication 1, dans lequel ladite première partie est un PDMOS flottant et ladite seconde partie est un NDMOS non flottant.

8. Appareil tel qu'énoncé dans la revendication 1, ledit circuit d'entrée comprenant un premier et un second sous-circuits, ledit premier sous-circuit étant actif lorsque ladite tension d'entrée est définie audit deuxième niveau de tension et ladite tension d'échantillonnage est définie audit premier niveau de tension, et étant non actif sinon, ledit second sous-circuit étant actif lorsque à la fois ladite tension d'entrée et ladite tension d'échantillonnage sont définies audit premier niveau de tension, et étant non actif sinon.

9. Appareil tel qu'énoncé dans la revendication 8, lesdits sous-circuits étant connectés entre ledit troisième niveau de tension et ledit quatrième niveau de tension.

10. Appareil tel qu'énoncé dans la revendication 8, dans lequel ledit premier sous-circuit et ledit second sous-circuit procurent chacun une entrée vers un circuit de commutation, ledit circuit de commutation ayant une sortie étant une desdites bornes d'entrée, ledit circuit de commutation connecte la sortie dudit circuit de commutation audit troisième niveau de tension lorsque ledit premier sous-circuit est actif, et ledit circuit de commutation définit la sortie dudit circuit de commutation à un cinquième niveau de tension lorsque ledit second sous-circuit est actif.

11. Appareil tel qu'énoncé dans la revendication 10, dans lequel lorsque la sortie dudit circuit de commutation est connectée audit troisième niveau de tension, ladite partie dudit circuit de sortie dont la borne d'entrée est connectée à la sortie dudit circuit de commutation est non active, et lorsque la sortie dudit circuit de commutation est définie à un cinquième niveau de tension, cela entraîne que ladite partie dudit circuit de sortie dont la borne d'entrée est connectée à la sortie dudit circuit de commutation est active.

12. Appareil tel qu'énoncé dans la revendication 11, dans lequel la sortie dudit circuit de commutation est électriquement isolée lorsque ledit premier et ledit second sous-circuits sont non actifs.

13. Appareil tel qu'énoncé dans la revendication 10, dans lequel ledit premier sous-circuit et ledit second sous-circuit comprennent une concaténation d'un PMOS, dont la grille est connectée à son drain, et d'un NDMOS, dont la grille est l'entrée dudit sous-circuit.

14. Appareil tel qu'énoncé dans la revendication 13, dans lequel l'entrée dudit premier sous-circuit est un ET logique de la tension d'entrée logiquement inversée et de la tension d'échantillonnage.

15. Appareil tel qu'énoncé dans la revendication 14, dans lequel l'entrée dudit second sous-circuit est un ET logique de la tension d'entrée et de la tension d'échantillonnage.

16. Appareil tel qu'énoncé dans la revendication 15, dans lequel ledit circuit de commutation comprend un premier commutateur, étant commandé par l'entrée fournie par ledit premier sous-circuit, une première extrémité dudit premier commutateur étant connectée audit troisième niveau de tension, ledit circuit de commutation comprenant en outre un élément de conduction à sens unique, une première extrémité dudit élément étant connectée à la seconde extrémité dudit premier commutateur, une seconde extrémité dudit élément étant connectée à l'entrée fournie par ledit second sous-circuit, ladite seconde extrémité dudit premier commutateur et ladite première extrémité dudit élément étant la sortie dudit circuit de commutation.

17. Appareil tel qu'énoncé dans la revendication 16, dans lequel ledit premier commutateur est un PMOS, dont la grille est commandée par l'entrée fournie par ledit premier sous-circuit.

18. Appareil tel qu'énoncé dans la revendication 16, dans lequel ledit élément de conduction à sens unique est une diode.

19. Appareil tel qu'énoncé dans la revendication 16, dans lequel ledit élément de conduction à sens unique est un PMOS, dont la grille est connectée à sa source et à son substrat.

20. Appareil tel qu'énoncé dans la revendication 10, comprenant en outre un deuxième et un troisième commutateurs et un circuit, commandant lesdits deuxième et troisième commutateurs, une première extrémité dudit deuxième commutateur étant connectée audit troisième niveau de tension, une seconde extrémité dudit deuxième commutateur étant connectée à l'entrée fournie par ledit premier sous-circuit audit circuit de commutation, une première extrémité dudit troisième commutateur étant connectée audit troisième niveau de tension, une seconde extrémité dudit troisième commutateur étant connectée à l'entrée fournie par ledit deuxième sous-circuit audit circuit de commutation, ledit circuit fermant lesdits deuxième et troisième commutateurs lorsque la borne d'entrée de ladite partie dudit circuit de sortie étant connectée à la sortie dudit circuit de commutation doit être électriquement isolée dudit circuit d'entrée.

21. Appareil tel qu'énoncé dans la revendication 20, lesdits deuxième et troisième commutateurs étant des dispositifs PMOS dont les grilles sont connectées audit circuit.

22. Appareil tel qu'énoncé dans la revendication 20, dans lequel ledit circuit est une concaténation de deux PMOS, dont les grilles sont connectées à leur drain et d'un dispositif NDMOS, dont la grille est connectée à ladite tension d'échantillonnage.

23. Appareil tel qu'énoncé dans la revendication 1, lequel est réalisé selon une technologie CMOS.

24. Appareil tel qu'énoncé dans la revendication 1, lesdites première et seconde parties étant électriquement équivalentes.

25. Appareil tel qu'énoncé dans la revendication 24, comprenant deux desdits circuits d'entrée, chacun desdits circuits d'entrée étant connecté à une desdites bornes d'entrée, les deux dits circuits d'entrée étant adaptés pour définir au niveau de la borne d'entrée, à laquelle ledit circuit d'entrée est connecté, un niveau de tension de borne d'entrée lié à ladite tension d'entrée lorsque ladite tension d'échantillonnage est définie à un premier niveau de tension, et étant adaptés pour isoler électriquement la borne d'entrée, à laquelle ledit circuit d'entrée est connecté, lorsque ladite tension d'échantillonnage est définie à un second niveau de tension.

26. Appareil tel qu'énoncé dans la revendication 25, dans lequel lesdits niveaux de tension de borne d'entrée à définir au niveau desdites bornes d'entrée sont sélectionnés de telle sorte que :
lorsque ladite tension d'entrée est définie à un premier niveau de tension, les deux dites parties dudit circuit de sortie sont actives, définissant ainsi ledit appareil dans un mode de conduction,
lorsque ladite tension d'entrée est définie à un second niveau de tension, les deux dites parties dudit circuit de sortie sont non actives, définissant ainsi ledit appareil dans un mode de non conduction,

27. Appareil tel qu'énoncé dans la revendication 26, dans lequel ladite tension de sortie est liée à un troisième niveau de tension lorsque ledit appareil est dans un mode de conduction, et est électriquement isolée dudit troisième niveau de tension lorsque ledit appareil est dans un mode de non conduction.

28. Appareil tel qu'énoncé dans la revendication 24, dans lequel chaque partie dudit circuit de sortie est connectée d'un côté audit troisième niveau de tension.

29. Appareil tel qu'énoncé dans la revendication 24, dans lequel ladite première partie et ladite seconde partie sont des PDMOS flottants en série avec une diode.

30. Appareil tel qu'énoncé dans la revendication 28, dans lequel au moins un desdits deux circuits d'entrée comprend deux sous-circuits, lesdits sous-circuits étant connectés entre un quatrième niveau de tension et le côté du circuit de sortie commandé par ledit circuit d'entrée n'étant pas connecté audit troisième niveau de tension.
